(19) **Europäisches Patentamt**

**European Patent Office**

**Office européen des brevets**

(11) **EP 1 081 849 B1**

(12) **FASCICULE DE BREVET EUROPEEN**

| | |
|---|---|
| (45) Date de publication et mention de la délivrance du brevet:<br>**21.12.2005 Bulletin 2005/51** | (51) Int Cl.⁷: **H03F 3/68**, H04B 7/24,<br>H03F 1/26, H03J 5/24,<br>H03F 3/191 |

(21) Numéro de dépôt: **00410110.1**

(22) Date de dépôt: **30.08.2000**

(54) **Circuit amplificateur à double bande passante et tête de réception radiofréquence**

Zweiband-Verstärkungsschaltung und Hochfrequenempfangsteil

Dual band amplifier circui and radio frequency receiving unit

(84) Etats contractants désignés:
**DE FR GB IT**

(30) Priorité: **31.08.1999 FR 9911032**

(43) Date de publication de la demande:
**07.03.2001 Bulletin 2001/10**

(73) Titulaire: **STMicroelectronics S.A.**
**92120 Montrouge (FR)**

(72) Inventeur: **Belot, Didier**
**38140 Rives (FR)**

(74) Mandataire: **de Beaumont, Michel**
**1bis, rue Champollion**
**38000 Grenoble (FR)**

(56) Documents cités:
**EP-A- 0 911 969**   **DE-B- 1 056 199**
**US-A- 3 768 020**   **US-A- 5 521 554**

- **BOUISSE G: "DUAL BAND RF POWER AMPLIFIERS" MOTOROLA TECHNICAL DEVELOPMENTS,US,MOTOROLA INC. SCHAUMBURG, ILLINOIS, vol. 34, 1 mars 1998 (1998-03-01), pages 128-129, XP000781050**

## Description

La présente invention concerne le domaine des circuits amplificateurs à faible bruit (LNA) et, plus particulièrement, de tels amplificateurs utilisés dans des têtes de réception de signaux radiofréquence. L'invention s'applique plus particulièrement aux amplificateurs à faible bruit et aux têtes de réception radiofréquence destinées aux circuits de téléphonie mobile susceptibles de fonctionner dans deux bandes de fréquences distinctes, par exemple, centrées sur des fréquences de 950 MHz et de 1,85 GHz. De tels systèmes de téléphonie mobile sont appelés des systèmes bibande et les fréquences centrales associées à chaque bande dépendent des normes de télécommunication. Par exemple, pour les standards GSM et DCS, les bandes de réception (qui transitent par une tête à laquelle s'applique l'invention) sont respectivement comprises entre 925 -960 MHz et 1805-1880 MHz, les bandes d'émission étant respectivement comprises entre 880-915 MHz et 1710-1785 MHz. Le recours aux systèmes bibande est lié à un besoin d'augmenter la capacité des réseaux de téléphonie mobile.

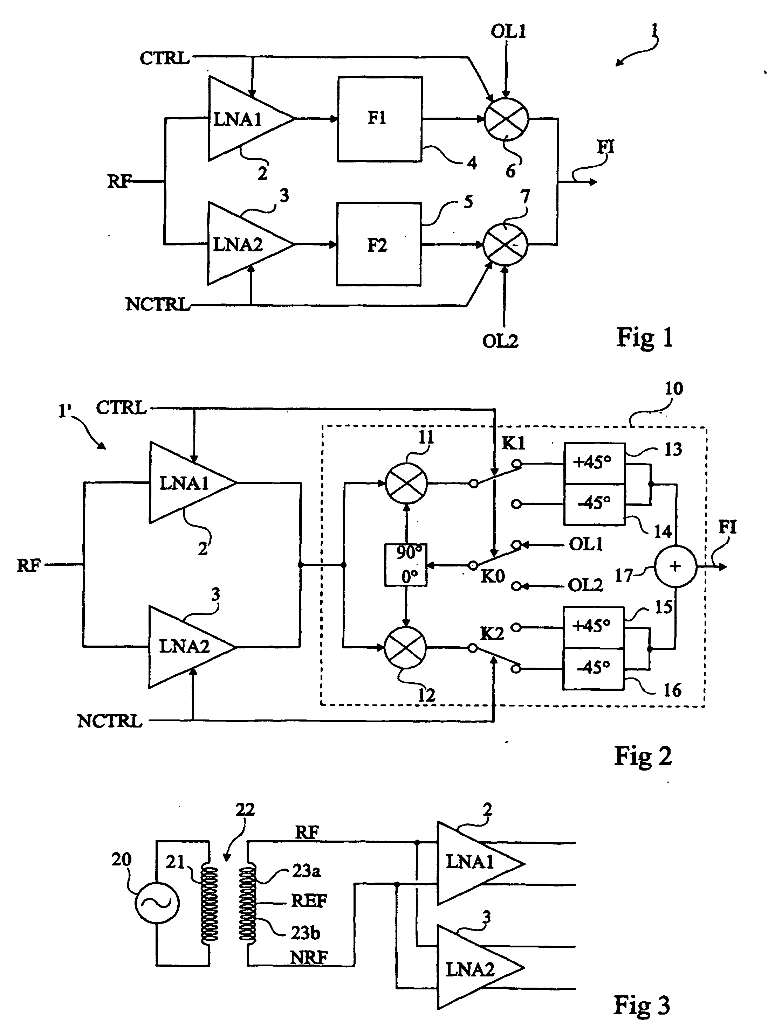

La figure 1 représente, de façon très schématique, un exemple classique de tête 1 de réception radiofréquence de type bibande. La tête 1 reçoit un signal radiofréquence RF qui provient d'une antenne de réception (non représentée) en transitant, le cas échéant, par un coupleur d'antenne et/ou un transformateur d'isolement (non représenté). Le plus souvent et comme on le verra par la suite, le signal radiofréquence est de forme différentielle. Toutefois, par souci de simplification, la figure 1 sera exposée en relation avec un fonctionnement non différentiel.

Le signal RF est envoyé sur deux amplificateurs à faible bruit 2, 3 (LNA1, LNA2), respectivement associés à chaque fréquence centrale des bandes passantes du système. Par exemple, l'amplificateur 2 présente un gain maximum pour une fréquence de l'ordre de 1850 MHz, tandis que l'amplificateur 3 présente un gain maximum pour une fréquence de l'ordre de 950 MHz. Chaque amplificateur 2, 3 est associé, en sortie, à un filtre 4, 5 (F1, F2) de type passe-bande. Les filtres 4 et 5 servent à éliminer les fréquences images des fréquences centrales respectives des bandes passantes. Ces filtres sont généralement réalisés en technologie dite coplanaire et sont du type à ondes de surface. Dans l'exemple ci-dessus, le filtre F1 est centré sur la fréquence de 950 MHz tandis que le filtre F2 est centré sur la fréquence de 1850 MHz. Les sorties respectives des filtres 4 et 5 sont envoyées sur des premières entrées de deux multiplieurs 6, 7. Les deuxièmes entrées respectives des multiplieurs 6 et 7 reçoivent une fréquence issue d'un oscillateur local OL1, OL2. Les fréquences respectives des oscillateurs locaux OL1 et OL2 sont choisies de sorte que, en sortie d'un des multiplieurs 6 et 7, la fréquence centrale du signal FI correspond, quel que soit le canal, à la fréquence intermédiaire choisie pour la tête radiofréquence. Selon les applications, la fréquence du signal FI de sortie de la tête 1 est la fréquence centrale du canal, ou une autre basse fréquence arbitraire (par exemple, de l'ordre de la centaine de MHz, voire moins). Dans les applications à la téléphonie mobile, la largeur de chaque canal est de 200 kHz.

Les amplificateurs 2 et 3 et les multiplieurs 6 et 7 sont commandés par des signaux, respectivement CTRL et NCTRL, dont le rôle est de sélectionner l'une des deux voies parallèles de la tête radiofréquence selon la bande dans laquelle se trouve le canal reçu.

La figure 2 représente, toujours de façon très schématique, un deuxième exemple de tête 1' de réception radiofréquence. Comme dans l'exemple de la figure 1, chaque bande de fréquences est associée à un amplificateur à faible bruit, respectivement 2, 3 dont l'activation est obtenue par un signal de commande respectivement CTRL et NCTRL. La différence essentielle entre les exemples des figures 1 et 2 est que, en figure 2, on utilise un mélangeur 10, réjecteur de fréquence image. Un tel mélangeur comprend deux multiplieurs d'entrée 11, 12 recevant, chacun, le signal issu de l'amplificateur 2 ou 3 en service ainsi que la fréquence délivrée par un oscillateur local OL1 ou OL2, respectivement déphasée de 90° pour le multiplieur 11 et non-déphasée pour le multiplieur 12. La sélection de l'oscillateur local OL1 ou OL2 à utiliser est effectuée au moyen d'un commutateur Ko commandé, par exemple, par l'un des signaux CTRL ou NCTRL afin de sélectionner l'oscillateur local adapté à l'amplificateur 2 ou 3 utilisé. Les sorties respectives des multiplieurs 11 ou 12 sont individuellement envoyées, par l'intermédiaire de sélecteurs, respectivement K1 et K2, sur des déphaseurs de plus ou moins 45°. Ainsi, le multiplieur 11 est associé à deux déphaseurs 13 et 14, respectivement de +45° et de -45°, dont les entrées respectives correspondent à deux bornes de sortie du sélecteur K1 dont l'entrée est reliée à la sortie du multiplieur 11. De même, le multiplieur 12 est associé à deux déphaseurs 15 et 16 respectivement de +45° et de -45° dont les entrées respectives sont associées à deux bornes de sortie du sélecteur K2 dont la borne d'entrée est connectée à la sortie du multiplieur 12. Les bornes de sortie des déphaseurs 13 et 14 sont reliées à une première entrée d'un sommateur 17 tandis que les bornes de sortie des déphaseurs 15 et 16 sont reliées à une deuxième entrée de ce sommateur 17, la sortie du sommateur 17 délivrant le signal à fréquence intermédiaire FI. Bien entendu, un seul déphaseur de chaque paire 13, 14 ou 15, 16 est utilisé selon la bande radiofréquence reçue. De plus, les déphaseurs sont utilisés en opposition, c'est-à-dire que si la sortie du multiplieur 11 est déphasée de +45°, la sortie du multiplieur 12 est elle déphasée de -45° et inversement. Les sélecteurs K1 et K2 sont, par exemple, respectivement commandés par les signaux CTRL et NCTRL pour sélectionner les déphasages respectifs à apporter en fonction de la fréquence du signal RF.

Le fonctionnement des têtes radiofréquence bibande telles qu'illustrées aux figures 1 et 2 est parfaitement connu et ne sera pas détaillé plus avant. On notera simplement que des systèmes de mélangeur à réjection de fréquence image sont décrits dans de nombreuses publications, par exemple, "A 2.5 GHz BiCMOS image reject front end" de M.D. Mc Donald, dans ISSCC93, paper TP94, pages 144-145 , "An improved Image Reject Mixer and a Vco fully integrated in a BiCMOS process" de D. Pache, J.M. Fournier, G. Billot et P. Senn dans Proceed in Nomadic Microwave for Mobile Communications and Detection, Arcachon, Nov 1995, et "An improved 3 V 2 GHz BiCMOS Image Reject Mixer IC" de D. Pache, J.M. Fournier, G. Billot et P. Senn dans Proceeding of CICC, mai 1995, USA, dont les contenus respectifs sont incorporés par référence expresse.

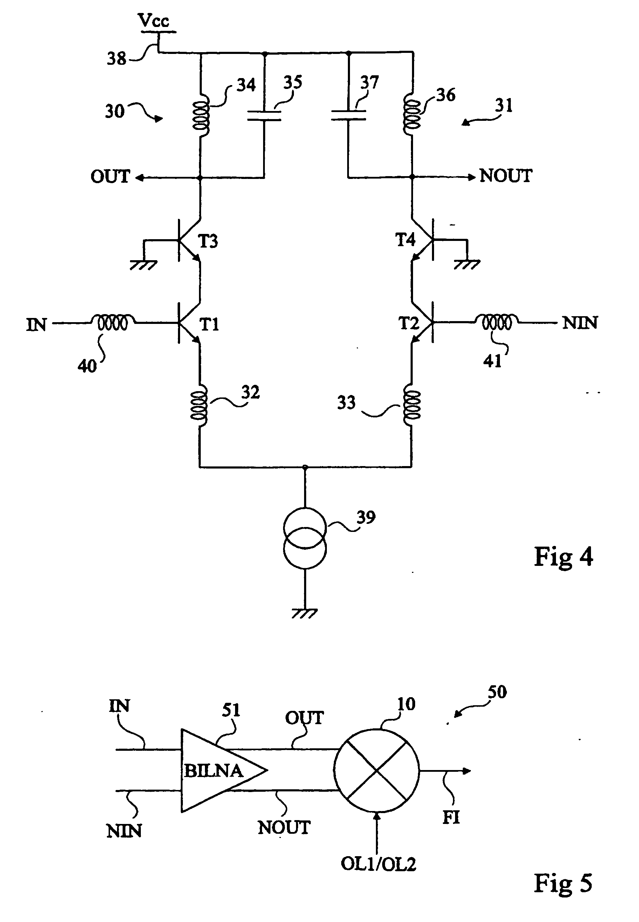

La figure 3 représente, de façon très schématique, la partie amont d'une tête de réception radiofréquence 1, 1' telle qu'illustrée par les figures 1 et 2, c'est-à-dire la partie située en amont des amplificateurs 2, 3. Dans l'exemple de la figure 3, on a représenté le cas où les amplificateurs à faible bruit reçoivent des signaux différentiels, ce qui est de plus en plus souvent le cas. Comme l'illustre la figure 3, une antenne 20 capte le signal radiofréquence. Cette antenne est associée à l'enroulement primaire 21 d'un transformateur 22 dont l'enroulement secondaire est à point milieu, de sorte qu'une première partie 23a délivre le signal RF tandis qu'une deuxième partie 23b délivre le signal NRF inversé. Le point milieu de l'enroulement secondaire reçoit une référence de tension REF, par exemple, la masse. Les signaux RF et NRF sont envoyés chacun sur les deux entrées différentielles des amplificateurs à faible bruit 2 et 3. Chaque amplificateur 2, 3 possède, de même, deux sorties différentielles à destination des filtres 4 et 5 (figure 1) ou du mélangeur 10 (figure 2).

Un inconvénient des têtes bibande classiques de réception de signaux radiofréquences est que les amplificateurs à faible bruit sont particulièrement encombrants. Par conséquent, le recours à deux amplificateurs à faible bruit pour chaque fréquence du système bibande nuit à la miniaturisation du système, que ce soit en surface de silicium pour l'intégration de la tête radiofréquence ou en nombre de bornes d'entrée/sortie, chaque fréquence ayant son entrée spécifique. Cela introduit notamment deux réseaux d'adaptation externes. Comme l'illustre la figure 4 ci-dessous, les signaux d'entrée des amplificateurs à faible bruit font généralement l'objet d'une adaptation d'impédance au moyen d'éléments inductifs et capacitifs externes. Le recours à deux amplificateurs à faible bruit augmente d'autant la surface de cuivre nécessaire pour la réalisation des composants inductifs externes.

La figure 4 représente un exemple classique de circuit amplificateur à faible bruit ayant une structure différentielle. Un tel amplificateur est basé sur l'utilisation de deux amplificateurs d'entrée, par exemple, des transistors bipolaires T1 et T2, associés chacun en série avec deux autres amplificateurs, par exemple des transistors bipolaires T3 et T4, de façon à former deux montages cascode. Chaque montage cascode constituant l'une des branches du circuit différentiel est associé à un circuit bouchon (circuit LC), respectivement 30, 31, monté en série avec un des amplificateurs T3 et T4. De plus, chaque amplificateur T1, T2 est associé à une inductance respectivement 32, 33 de compensation dont le rôle sera expliqué par la suite. Les circuits LC 30 et 31 sont respectivement constitués d'une inductance 34 en parallèle avec un condensateur 35 et d'une inductance 36 en parallèle avec un condensateur 37. Les inductances 36 et 34 ont les mêmes valeurs, de même que les condensateurs 35 et 37.

Une première borne des inductances 34, 36 et des condensateurs 35, 37 est connectée à une borne 38 d'application d'une tension d'alimentation $V_{cc}$. Les deuxièmes bornes respectives des inductances 34 et 36 et des condensateurs 35 et 37 sont, dans l'exemple de la figure 4, connectées au collecteur du transistor T3 ou T4 selon le circuit LC 30 ou 31 auxquelles elles appartiennent. Les bases de transistors T3 et T4 sont connectées à la masse tandis que leurs émetteurs sont connectés aux collecteurs respectifs des transistors T1 et T2. Les émetteurs respectifs des transistors T1 et T2 sont reliés à une première borne des inductances de compensation 32 et 33 auxquels ils sont associés. Les deuxièmes bornes respectives des inductances 32 et 33 sont reliées à une première borne d'une source de courant 39 dont l'autre borne est connectée à la masse. Les bases respectives des transistors T1 et T2 reçoivent des signaux d'entrée IN et NIN par l'intermédiaire d'inductances 40 et 41 d'adaptation dont le rôle sera exposé ci-après. Les sorties différentielles OUT et NOUT de l'amplificateur à faible bruit de la figure 3 sont définies par les collecteurs respectifs des transistors T3 et T4.

Pour obtenir un amplificateur à faible bruit, c'est-à-dire présentant un fort taux de réjection hors de la bande passante souhaitée et un fort gain pour la fréquence centrale de cette bande passante, les inductances 32, 33, 34, 36, 40 et 41 ainsi que les condensateurs 35 et 37 sont adaptés en conséquence.

Les inductances de base 40 et 41 d'émetteur 32 et 33 des transistors respectifs T1 et T2 permettent d'adapter l'impédance d'entrée de l'amplificateur. Les inductances 32 et 33 permettent l'adaptation avec la capacité de chaque entrée du circuit différentiel, essentiellement constituée par la capacité base-émetteur de chaque transistor T1 et T2. Les inductances 40 et 41 permettent l'adaptation avec la capacité de base des transistors T1 et T2. Les inductances 40 et 41 symbolisent en fait les inductances liées au trajet des signaux d'entrée ainsi qu'aux inductances des plots de connexion et du boîtier contenant le circuit intégré. On notera que plus l'impédance d'entrée des transistors T1 et T2 est inductive, plus la bande est étroite.

Le recours à une structure différentielle permet d'obtenir une réjection de mode commun, tandis que les montages en cascode rendent l'impédance d'entrée indépendante des charges réactives constituées par les circuits LC 30 et 31. Pour obtenir un amplificateur à faible bruit, il faut que les circuits LC respectifs résonnent à la valeur choisie, c'est-à-dire à la fréquence centrale de la bande utile sélectionnée. C'est pourquoi chaque bande de la tête de réception est associée à un amplificateur LNA qui lui est propre.

Un circuit amplificateur tel qu'illustré par la figure 4 est décrit, par exemple, dans la demande de brevet européen EP-A-0 911 969 de la demanderesse dont le contenu est considéré ici comme connu.

Outre les problèmes liés à la place occupée par deux amplificateurs à faible bruit, les besoins de commutateurs supplémentaires pour sélectionner celui des amplificateurs qui doit fonctionner peuvent engendrer des retards à la mise en route du système par les temps de commutation. En outre, le recours à des commutateurs prend encore de la place et nécessite des signaux de commande.

La présente invention vise à pallier les inconvénients des têtes de réception radiofréquence connues.

Plus particulièrement, un objet de la présente invention est de proposer une nouvelle tête de réception de signaux radiofréquence n'utilisant qu'un seul amplificateur à faible bruit, et étant susceptible d'être affectée à un système bibande.

Un autre objet de la présente invention est de proposer un amplificateur à faible bruit et à deux bandes passantes distinctes.

L'invention vise également à proposer une solution qui minimise le recours à des commutateurs de manière à minimiser la place prise par le circuit sous forme intégrée.

L'invention vise en outre à proposer une solution qui soit particulièrement adaptée aux systèmes de téléphonie mobile.

Pour atteindre ces objets, la présente invention prévoit un circuit amplificateur tel que defini dans la revendication 1.

Selon un mode de réalisation de la présente invention, lesdites impédances sont associées en série et sont dimensionnées pour présenter chacune une valeur maximale et un facteur de qualité élevé sur l'une des deux fréquences de fonctionnement du circuit.

Selon un mode de réalisation de la présente invention, chaque impédance est constituée d'une inductance en parallèle avec un condensateur.

Selon un mode de réalisation de la présente invention, les rapports respectifs entre l'inductance et le condensateur de chaque impédance sont compris entre 3000 et 4500.

Selon un mode de réalisation de la présente invention, les inductances et condensateurs des impédances sont dimensionnés de sorte que la racine carrée du rapport entre l'inductance et le condensateur de la première impédance soit supérieure à $10^{10}$ fois la valeur de l'inductance de la deuxième impédance, et que la racine carrée du rapport entre l'impédance et le condensateur de la deuxième impédance soit supérieure à $0,5.10^{10}$ fois la valeur de l'inductance de la première impédance.

Selon un mode de réalisation de la présente invention, les impédances respectives des entrées différentielles du circuit amplificateur sont dimensionnées pour obtenir une adaptation large bande couvrant les deux bandes de fréquences de fonctionnement de l'amplificateur.

L'invention prévoit également une tête de réception de signaux radiofréquence propre à fonctionner sur deux bandes de fréquences différentes, comportant un circuit amplificateur tel que ci-dessus.

Ces objets, caractéristiques et avantages, ainsi que d'autres de la présente invention seront exposés en détail dans la description suivante de modes de réalisation particuliers faite à titre non-limitatif en relation avec les figures jointes parmi lesquelles :

les figures 1 à 4 qui ont été décrites précédemment sont destinées à exposer l'état de la technique et le problème posé ;
la figure 5 représente, de façon très schématique, un mode de réalisation d'une tête de réception radiofréquence selon la présente invention ;
la figure 6 illustre la caractéristique impédance-fréquence d'une charge réactive d'un amplificateur à faible bruit selon l'invention ; et
la figure 7 représente un mode de réalisation d'un amplificateur différentiel à faible bruit selon la présente invention.

Les mêmes éléments ont été désignés par les mêmes références aux différentes figures. Pour des raisons de clarté, seuls les éléments de l'amplificateur et de la tête de réception radiofréquence qui sont nécessaires à la compréhension de l'invention ont été représentés aux figures et seront décrits par la suite. En particulier, la partie de réception proprement dite (antenne, transformateur) qui a été représentée de façon très schématique en figure 3 ne sera pas détaillée plus avant et ne fait pas l'objet de la présente invention. De même, l'exploitation des signaux en fréquence intermédiaire ne fait pas l'objet de la présente invention et ne sera pas détaillée.

L'invention tire son origine d'une nouvelle approche de l'inventeur qui est de rechercher la solution aux problèmes à l'intérieur de l'amplificateur à faible bruit plutôt que de façon externe.

La présente invention tire profit de la structure cascode d'un amplificateur pour réaliser un amplificateur à faible bruit en utilisant pleinement l'indépendance de l'impédance d'entrée par rapport aux impédances des circuits bouchons (LC) constituant les charges réactives.

Ainsi, selon la présente invention, on dimensionne les impédances d'entrée des amplificateurs d'entrée du circuit pour obtenir une large bande passante en entrée qui couvre les deux bandes utiles souhaitées pour le système.

Une autre caractéristique de l'invention est de prévoir des charges réactives ayant deux fréquences de résonances distinctes.

Pour ce faire, une première solution est de prévoir deux circuits LC pour chaque branche du circuit amplificateur différentiel et un sélecteur du circuit LC en fonction de la bande de fréquences du signal reçu.

Cette solution ne constitue toutefois pas une solution préférée dans la mesure où elle nécessite le recours à des commutateurs dont les résistances à l'état passant risquent de dégrader le facteur de qualité de l'amplificateur. En dégradant ce facteur de qualité, on élargit alors la bande passante, on augmente le bruit et on diminue le gain de l'amplificateur.

La figure 5 représente, de façon très schématique, un mode de réalisation d'une tête de réception radiofréquence 50 selon la présente invention. Cette tête de réception radiofréquence est essentiellement constituée d'un circuit amplificateur bibande à faible bruit 51 (BILNA). Le circuit 51 est à structure différentielle et reçoit les signaux radiofréquence d'entrée IN et NIN correspondant, par exemple, aux signaux RF et NRF de la figure 3. Les sorties différentielles OUT et NOUT de l'amplificateur 51 sont envoyées sur des entrées différentielles d'un mélangeur à réjection de fréquence image 10 classique recevant, outre des signaux de commande non représentés, des fréquences issues d'oscillateurs locaux OL1 et OL2. De façon classique, la sortie du mélangeur 10 délivre le signal FI à la fréquence intermédiaire souhaitée pour le système.

Une caractéristique de la présente invention est d'utiliser, comme charge réactive des montages cascodes d'un amplificateur à faible bruit, des impédances réactives qui ne présentent pas la même valeur sur toute la bande de fréquence. Selon un mode de réalisation préféré de l'invention, ces impédances réactives sont réalisées sous la forme de deux impédances associées en série. Une première des impédances présente une valeur maximale pour une première des deux fréquences du système bibande et une valeur la plus faible possible pour l'autre des fréquences. L'autre impédance présente, à l'inverse, une valeur maximale pour la deuxième fréquence et une valeur la plus faible possible pour la première fréquence. Au moyen de telles impédances réactives, le circuit d'amplificateur obtenu a un gain présentant deux maxima, respectivement, aux deux fréquences centrales du système bibande.

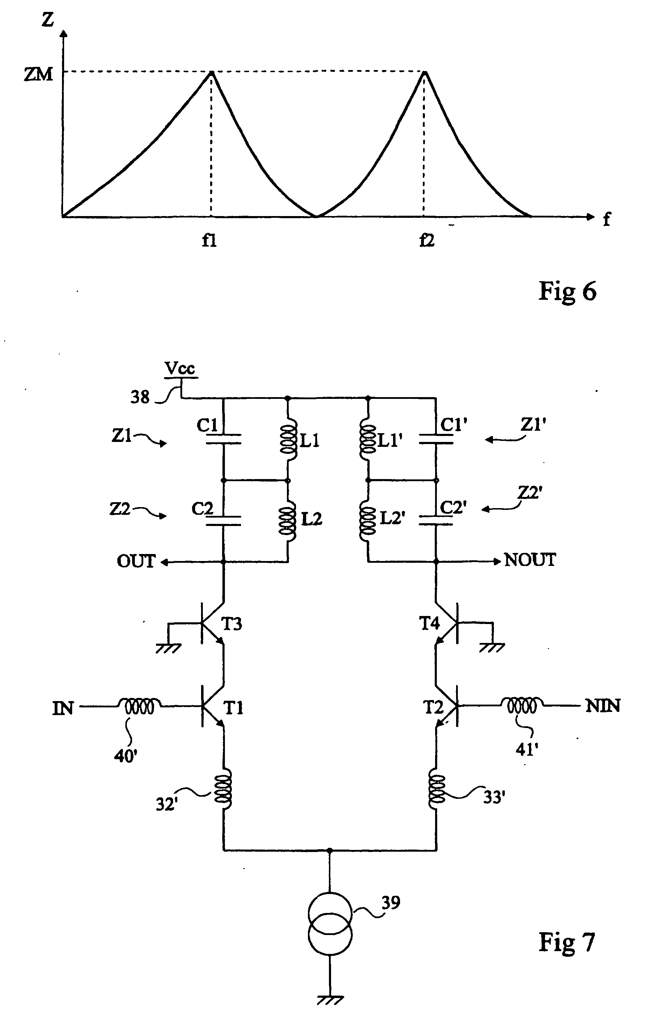

La figure 6 représente la caractéristique impédance-fréquence d'une impédance réactive d'un circuit amplificateur à faible bruit selon l'invention. Comme l'illustre la figure 6, l'impédance présente un maximum ZM aux deux fréquences f1 et f2 de fonctionnement du système. Le premier pic à la fréquence f1 est essentiellement dû à la première impédance utilisée tandis que le deuxième pic est essentiellement dû à la deuxième impédance utilisée. Comme cela a été indiqué précédemment, la contribution de chaque impédance est minimale lorsque l'autre impédance apporte une contribution maximale. Par conséquent, l'impédance Z diminue fortement dès que l'on s'écarte des fréquences f1 et f2.

On notera que, si les deux niveaux maximum d'impédance ont été représentés comme étant identiques à la figure 6, il s'agit là simplement d'un exemple, et ces niveaux pourront différer l'un de l'autre.

On notera également que, pour un circuit amplificateur à structure différentielle, chaque branche de la structure comporte une double impédance réactive selon l'invention.

La présente invention tire profit du fait que les fréquences f1 et f2 souhaitées pour le système bibande sont suffisamment éloignées l'une de l'autre pour permettre à la première impédance réactive en série d'être négligeable par rapport à la deuxième impédance et vice versa selon la fréquence du système.

La figure 7 représente un mode de réalisation d'un amplificateur différentiel à faible bruit selon l'invention. Cette figure reprend les éléments d'un amplificateur classique tel qu'illustré par la figure 4, et diffère de celui-ci essentiellement par la disposition de deux impédances réactives Z1, Z2 et zl', z2' à la place des circuits LC 30 et 31 de la figure 4.

Côté première branche (transistors T1, T3), l'impédance Z1 est constituée d'un condensateur C1 en parallèle avec une inductance L1, et l'impédance Z2 est constituée d'un condensateur C2 en parallèle avec une inductance L2. Côté deuxième branche (transistors T2, T4) l'impédance Z1' est constituée d'un condensateur C1' en parallèle avec une inductance L1', et l'impédance Z2' est constituée d'un condensateur C2' en parallèle avec une inductance L2'.

On notera que, selon l'invention, les inductances d'entrée respectives 40' et 41' et les inductances d'émetteurs respectives 32' et 33' sont dimensionnées pour présenter un faible facteur de qualité, de façon à obtenir une adaptation d'impédance d'entrée couvrant les deux bandes de fréquence du système.

On notera également que les valeurs des condensateurs et inductances des impédances réactives des deux branches sont symétriques. Par conséquent, C1=C1', L1=L1', C2=C2' et L2=L2'.

Une autre caractéristique de la présente invention est que les valeurs respectives des condensateurs et inductances des impédances réactives sont adaptées aux valeurs maximales souhaitées pour l'impédance du circuit amplificateur, de façon à obtenir un fort gain aux fréquences f1 et f2. Cela est compatible avec la recherche de disposer de deux bandes étroites pour obtenir un facteur de bruit faible sur la bande amplifiée.

Une autre caractéristique que doivent respecter les valeurs respectives des condensateurs et des inductances des charges réactives est liée aux valeurs des fréquences f1 et f2. En effet, on doit dimensionner les condensateurs et inductances pour que $2\pi f1 =$

$1/\sqrt{L1C1}$ et $2\pi f2 = 1/\sqrt{L2C2}$.

Selon la présente invention, les inductances et condensateur sont, de préférence, dimensionnés de sorte que les rapports L1/C1 et L2/C2 sont tous deux compris entre 3000 et 4500.

A partir de ces rapports respectifs entre les inductances et les condensateurs, on obtient un ensemble de valeurs possibles pour dimensionner les composants L1, C1 et L2, C2 en fonction des fréquences f1 et f2 souhaitées. Le choix parmi cet ensemble de valeurs est, selon l'invention, effectué pour, d'une part, que chaque impédance soit minimale lorsque l'autre impédance est maximale et pour être compatible à une intégration du circuit amplificateur sous forme de circuit intégré.

Pour respecter ainsi la contrainte de bandes étroites distinctes, les composants sont, de préférence, dimensionnés de façon à respecter les relations suivantes : $\sqrt{L1C1} > 10^{10}$ L2, et $\sqrt{L2C2} > 0,5.10^{10}$ L1.

A titre d'exemple particulier de réalisation, adapté à une tête de réception radiofréquence pour un téléphone mobile bibande de fréquences de 950 MHz et de 1,85 GHz, on pourra utiliser, pour réaliser le circuit amplificateur de la figure 7, les valeurs suivantes :

L1 = 9 nH
C1 = 2,5 pF
L2 = 4,5 nH
C2 = 1,125 pF.

Avec de telles valeurs, on obtient des gains de plus de 20dB pour les fréquences f1 et f2, les modules respectifs des impédances maximales aux fréquences f1 et f2 sont de 250 et 273 Ohms pour les impédances, respectivement, Z1 et Z2.

On notera que ce qui a été exposé ci-dessus pour les impédances Z1 et Z2 est également valable pour les impédances Z1' et Z2'.

Pour l'association d'un amplificateur bibande à faible bruit selon l'invention à une tête de réception radiofréquence, on peut utiliser tout système classique de réjection de fréquence image en aval, de préférence, un mélangeur avec réjection de la fréquence image tel qu'illustré par la figure 2.

Un avantage de la présente invention est qu'elle permet de réduire le nombre de bornes d'entrée/sortie de la tête de réception puisqu'elle utilise un seul amplificateur.

Un autre avantage de la présente invention est qu'elle supprime tous délais de passage d'une bande à l'autre dans la mesure où le circuit d'amplificateur de l'invention fonctionne en permanence pour les deux bandes.

Un autre avantage de l'invention est qu'il n'est plus nécessaire de recourir à des signaux de commande pour l'activation d'un circuit amplificateur ou l'autre. Cela apporte un gain de surface et de consommation.

Appliquée à la téléphonie mobile, la présente invention présente l'avantage de participer activement à la réduction de l'encombrement et à l'augmentation de l'autonomie des téléphones portables.

Bien entendu, la présente invention est susceptible de diverses variantes et modifications qui apparaîtront à l'homme de l'art. En particulier, les dimensionnements des différents composants du circuit amplificateur à faible bruit bibande de l'invention sont à la portée de l'homme du métier à partir des relations et indications fonctionnelles données ci-dessus. De plus, on notera qu'un circuit amplificateur bibande selon l'invention peut être réalisé soit en transistors bipolaires soit en transistors MOS. En outre, la mise en oeuvre de l'invention est compatible avec la mise en oeuvre classique d'autres fonctions d'un circuit amplificateur à faible bruit. Par exemple, on pourra combiner l'invention avec une fonction d'amplificateur à double gain telle que décrite dans la demande de brevet européen EP-A-0 911 969 susmentionnée.

Enfin, on notera que si l'invention a été décrite ci-dessus en relation avec un amplificateur différentiel qui constitue un mode de réalisation préféré, la mise en oeuvre du principe de l'invention (impédances réactives en série) peut également s'effectuer dans un amplificateur à faible bruit de structure non différentielle. L'intégration, dans une tête de réception radiofréquence d'un téléphone mobile, d'un circuit amplificateur selon l'invention qu'il soit d'une structure différentielle ou non différentielle s'effectue de façon sensiblement identique à l'intégration d'un amplificateur classique.

Bien que l'invention ait été décrite ci-dessus en relation avec un système bibande, on notera qu'elle peut être transposée aisément à d'autre systèmes multibande, par exemple un système tribande, pourvu que les rapports entre les fréquences centrales voisines soient sensiblement identiques (par exemple, pour des fréquences f1 de 950 MHz et f2 de 1,85 GHz, il faut que la troisième fréquence centrale f3 soit approximativement de 450 MHz ou de 3,8 GHz. Pour une telle application, on veillera à ce que les règles d'impédance définies précédemment pour les fréquence f1 et f2 soient respectées pour f2 et f3 si f3>f2, ou f3 et f1 si f3<f1).

## Revendications

**1.** Circuit amplificateur comportant :

- deux branches identiques en parallèle constituées chacune d'un montage cascode d'un premier (T1, T2) et d'un deuxième (T3, T4) amplificateur, en série avec un circuit d'impédances réactives (Z1, Z2 ; Z1', Z2'), chaque circuit d'impédances réactives étant constitué de deux impédances présentant respectivement, une valeur maximale pour une première (F1) fréquence, et une deuxième fréquence (F2) différente de la première, de façon à constituer un circuit amplificateur bibande.

**2.** Circuit amplificateur selon la revendication 1, **caractérisé en ce que** lesdites impédances (Z1, Z2) sont associées en série et sont dimensionnées pour présenter chacune une valeur maximale et un facteur de qualité élevé sur l'une des deux fréquences (f1, f2) de fonctionnement du circuit.

**3.** Circuit amplificateur selon la revendication 1 ou 2, **caractérisé en ce que** chaque impédance (Z1, Z2) est constituée d'une inductance (L1, L2) en parallèle avec un condensateur (C1, C2).

**4.** Circuit amplificateur selon la revendication 3, **caractérisé en ce que** les rapports respectifs entre l'inductance (L1, L2) et le condensateur (C1, C2) de chaque impédance (Z1, Z2) sont compris entre 3000 et 4500.

**5.** Circuit amplificateur selon la revendication 3, **caractérisé en ce que** les inductances (L1, L2) et condensateurs (C1, C2) des impédances (Z1, Z2) sont dimensionnés de sorte que la racine carrée du rapport entre l'inductance (L1) et le condensateur (C1) de la première impédance (Z1) soit supérieure à $10^{10}$ fois la valeur de l'inductance (L2) de la deuxième impédance (Z2), et que la racine carrée du rapport entre l'impédance (L2) et le condensateur (C2) de la deuxième impédance (Z2) soit supérieure à $0{,}5.10^{10}$ fois la valeur de l'inductance (L1) de la première impédance (Z1).

**6.** Circuit amplificateur selon l'une quelconque des revendications 1 à 5, **caractérisé en ce que** les impédances respectives (40', 41') de ses entrées différentielles (IN, NIN) sont dimensionnées pour obtenir une adaptation large bande couvrant les deux bandes de fréquences de fonctionnement de l'amplificateur.

**7.** Tête de réception de signaux radiofréquence propre à fonctionner sur deux bandes de fréquences différentes, **caractérisée en ce qu'**elle comporte un circuit amplificateur selon l'une quelconque des revendications 1 à 6.

**Patentansprüche**

**1.** Eine Verstärkerschaltung, die Folgendes aufweist:

zwei identische parallele Zweige, die jeweils aus einer Kaskoden-Anordnung eines ersten (T1, T2) und eines zweiten (T3, T4) Verstärkers in Reihenschaltung mit einer Blindwiderstandsschaltung (reactive impedance circuit) (Z1, Z2; Z1', Z2') gebildet wird, wobei jede Blindwiderstandsschaltung jeweils zwei Impedanzen enthält, die einen maximalen Wert für eine erste (F1) und eine zweite (F2) Frequenz aufzeigen, zum Bilden einer Doppelbandverstärkungsschaltung.

**2.** Verstärkerschaltung nach Anspruch 1, **gekennzeichnet dadurch, dass** die Impedanzen (Z1, Z2) in Reihe zugeordnet sind, und so abgemessen sind, um jeweils einen maximalen Wert und einen hohen Qualitätsfaktor bei einer der zwei Betriebsfrequenzen (F1, F2) der Schaltung aufzuzeigen

**3.** Verstärkerschaltung nach Anspruch 1 oder 2, **gekennzeichnet dadurch, dass** jede Impedanz (Z1, Z2) durch eine Induktivität bzw. Spule (L1, L2) parallel zu einem Kondensator (C1, C2) gebildet wird.

**4.** Verstärkerschaltung nach Anspruch 3, **gekennzeichnet dadurch, dass** die jeweiligen Verhältnisse zwischen der Induktivität (L1, L2) und dem Kondensator (C1, C2) einer jeden Impedanz (Z1, Z2) zwischen 3000 und 4500 liegt.

**5.** Verstärkerschaltung nach Anspruch 3, **dadurch gekennzeichnet, dass** die Spulen (L1, L2) und die Kondensatoren (C1, C2) der Impedanzen (Z1, Z2) so abgemessen sind, dass die Quadratwurzel des Verhältnisses zwischen der Spule (L1) und dem Kondensator (C1) der ersten Impedanz (Z1) größer ist als das $10^{10}$-fache des Wertes der Spule (L2) der zweiten Impedanz (Z2), so dass die Quadratwurzel des Verhältnisses zwischen der Impedanz (L2) und der elektrischen Kapazität (C2) der zweiten Impedanz (Z2) größer ist als $0{,}5\times10^{10}$-fache des Wertes der Induktivität bzw Spule (L1) der ersten Impedanz (Z1).

**6.** Verstärkerschaltung nach einem der Ansprüche 1 bis 5, **dadurch gekennzeichnet, dass** sie differertzielle Eingänge (IN, NIN) aufweist, deren jeweilige Impedanzen (40', 41') so abgemessen sind, dass eine Breitbandanpassung, die die zwel Betriebsfrequenzbänder des Verstärkers abdeckt, erhalten wird.

**7.** Ein Funkfrequenzempfangskopf bzw -element, das in der Lage ist, bei zwei unterschiedlichen Frequenzbändern zu operieren, **dadurch gekennzeichnet, dass** es die Verstärkerschaltung nach einem der Ansprüche 1 bis 6 aufweist.

**Claims**

**1.** An amplifier circuit comprising:

two identical branches in parallel, each formed of a cascode assembly of a first (T1, T2) and of a second (T3, T4) amplifier, in series with a reactive impedance circuit (Z1, Z2; Z1', Z2'), each reactive impedance circuit including two impedances respectively exhibiting a maximum value for a first (F1) and a second (F2) frequency, to form a double-band amplifier circuit.

2. The amplifier circuit of claim 1, **characterized in that** said impedances (Z1, Z2) are associated in series and are sized to each exhibit a maximum value and a high quality factor on one of the two operating frequencies (f1, f2) of the circuit.

3. The amplifier circuit of claim 1 or 2, **characterized in that** each impedance (Z1, Z2) is formed by an inductance (L1, L2) in parallel with a capacitor (C1, C2).

4. The amplifier circuit of claim 3, **characterized in that** the respective ratios between the inductance (L1, L2) and the capacitor (C1, C2) of each impedance (Z1, Z2) range between 3,000 and 4,500.

5. The amplifier circuit of claim 3, **characterized in that** the inductances (L1, L2) and capacitors (C1, C2) of the impedances (Z1, Z2) are sized so that the square root of the ratio between the inductance (L1) and the capacitance (C1) of the first impedance (Z1) is greater than $10^{10}$ times the value of the inductance (L2) of the second impedance (Z2), and that the square root of the ratio between the impedance (L2) and the capacitance (C2) of the second impedance (Z2) is greater than $0.5*10^{10}$ times the value of the inductance (L1) of the first impedance (Z1).

6. The amplifier circuit of any of claims 1 to 5, **characterized in that** it comprises differential inputs (IN, NIN) the respective impedances (40', 41') of which are sized to obtain a wide band matching covering the two operating frequency bands of the amplifier.

7. A radio frequency reception head capable of operating on two bands of different frequencies, **characterized in that** it comprises the amplifier circuit of any of claims 1 to 6.

Fig 1

Fig 2

Fig 3

Fig 4

Fig 5

Fig 6

Fig 7